# EUROPEAN PATENT APPLICATION

(11) **EP 3 650 232 A1**
(43) Date of publication of application: **13.05.2020**
(21) Application number: 19206289.1
(22) Date of filing: 30.10.2019
(51) Int. Cl.: B41J 2/355, B41J 25/312

(54) **PRINTING SYSTEM**

(30) Priority: 31.10.2018 JP 2018205966
(71) Applicant: Brother Kogyo Kabushiki Kaisha, Aichi 467-8561 (JP)
(72) Inventor: FUJITA, Keisuke, Nagoya-shi,, Aichi 467-8562 (JP)
(74) Representative: J A Kemp LLP

(57) **Abstract**

A printing system includes a platen roller, a storage unit, a controller, and a printing device including a thermal head, a head drive source that is configured to move the thermal head in a first direction along which the thermal head approaches or separates from the platen roller, and at least a sensor that is configured to detect a position of the thermal head. In the printing system, the controller is configured to determine whether setting information of a print position is stored in the storage unit, detect the print position with the head drive source and the sensor when the setting information is not stored in the storage unit, and cause the head drive source to move the thermal head from a first position to a second position, when the setting information is stored in the storage unit.

## Description

### TECHNICAL FIELD

The present invention relates to a printing system.

### BACKGROUND ART

JP-A-2010-253905 discloses a thermal printer. The thermal printer includes an object-to-be-printed guide mechanism, a ribbon drive mechanism, a thermal head, and a platen roller. The printing-object guide mechanism moves a belt-like printing object along a printing-object path. The thermal head includes a print unit provided with a plurality of heating elements. The print unit protrudes toward the printing-object path. The ribbon drive mechanism moves an ink ribbon at a speed synchronized with the printing object.

With this configuration, the ink ribbon moves between the printing object in the printing-object path and the print unit of the thermal head. The platen roller alternately repeats a pressed state in which the printing object on the printing-object path is pressed toward the print unit and a non-pressed state in which the printing object is not pressed toward the print unit. The thermal head heats the print unit when the platen roller is in a pressed state. Ink in the ink ribbon interposed between the printing object and the print unit is transferred to the printing object by heating of the print unit. With this configuration, printing is performed on the printing object.

When the heating element of the thermal head is disposed at a print position which is a specific position of the platen roller during printing, the print position is preferably set in a printing device before starting printing. As a specific example of the print position, a position (hereinafter referred to as a vertex position), which is closest to the thermal head in the direction of relative movement between the thermal head and the platen roller, on the platen roller may be included.

As a specific example of a method in which detection of the vertex position is realized by a manual operation of an operator, there is a method of visually specifying the vertex position while the operator manually moves the thermal head. In this case, it may take time to set the vertex position. On the other hand, when the operation of detecting the vertex position is automated, there is a possibility that a process of the detection operation is complicated, and it takes time to set the vertex position. As such, in the printing device, there is a problem that it may take time to set the print position of the platen roller.

An object of the present invention is to provide a printing system capable of efficiently executing setting of a print position of a platen roller and shortening the time required to start printing.

### SUMMARY

According to an aspect of the invention, a printing system includes:
a platen roller;
a storage unit;
a controller; and
a printing device that includes:
   a thermal head;
   a head drive source that is configured to move the thermal head in a first direction along which the thermal head approaches or separates from the platen roller; and
   at least a sensor that is configured to detect a position of the thermal head, wherein the controller is configured to:
      determine, before a start of printing, whether setting information of a print position, which is a position of a heating element of the thermal head during printing, is stored in the storage unit,
      detect the print position with the head drive source and the sensor when it is determined that the setting information is not stored in the storage unit, and
      cause the head drive source to move the thermal head from a first position to a second position, which is closer to the platen roller than the first position and farther from the platen roller than a position of the thermal head in a state where the heating element is disposed at the print position, when it is determined that the setting information is stored in the storage unit.

### BRIEF DESCRIPTION OF DRAWINGS

Fig. 1 is a view illustrating an overview of a printing system;
Fig. 2 is a block diagram illustrating an electrical configuration of the printing system;
Fig. 3 is an explanatory view for explaining a print position detection process; and
Fig. 4 is a flowchart illustrating a main process.

### DESCRIPTION OF EMBODIMENTS

### <Overview of Printing System 1>

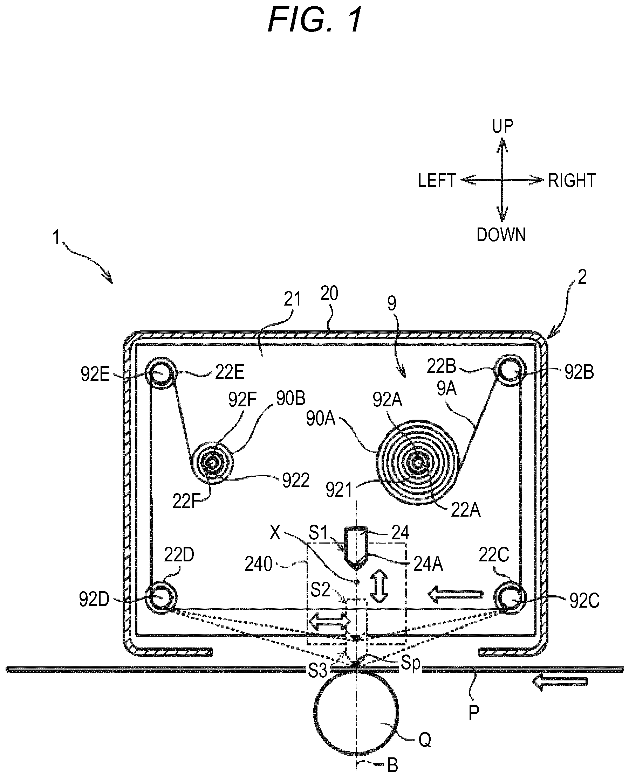

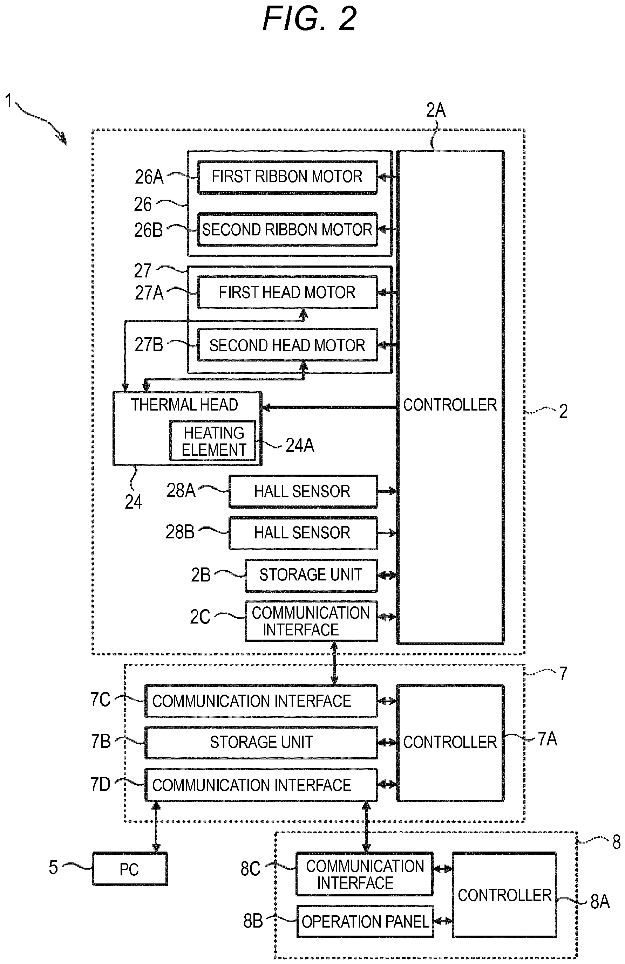

One embodiment of the present invention will be described with reference to the drawings. A printing system 1 is a system for performing thermal transfer printing. The printing system 1 performs printing on a print medium P conveyed by an external device 8 (see Fig. 2). A specific example of the external device 8, there is a packaging machine that conveys a packaging material. In this case, for example, the printing system 1 is used by being incorporated into a part of a convey line on which the print medium P is conveyed by the packaging machine. The printing system 1 includes a printing device 2, a controller 7 (see Fig. 2), and a platen roller Q. Hereinafter, in order to help understanding of the description of the drawings, the upper side, the lower side, the left, the right, the front, and the rear of each configuration included in the printing system 1 will be defined. The up, the down, the left, the right, the front, and the rear of the printing device 2 correspond to an upper side, a lower side, a left side, a right side, a front side, and a rear side of Fig. 1, respectively. In Fig. 1, a convey direction of the print medium P coincides with the horizontal direction. The print medium P is conveyed to the left by the external device 8. The printing device 2 performs printing on the print medium P by heating an ink ribbon 9A of an attached cassette 9 with a thermal head 24.

### <Cassette 9>

A cassette 9 has shafts 92A to 92F, a feed roll 90A, and a winding roll 90B. The shafts 92A to 92F are spindles that are rotatable around a rotation axis extending in the front-and-rear direction. A spool 921 to which one end of the ink ribbon 9A is connected is attached to the shaft 92A. A spool 922 to which the other end of the ink ribbon 9A is connected is attached to the shaft 92F. The ink ribbon 9A is wound around each of the spools 921 and 922 in a roll. The feed roll 90A is configured by winding the ink ribbon 9A around the spool 921. The winding roll 90B is configured by winding the ink ribbon 9A around the spool 922.

### <Printing Device 2>

A printing device 2 is disposed above the platen roller Q. The platen roller Q has a cylindrical shape and can rotate around a rotation axis extending in the front-and-rear direction. The printing device 2 includes a casing 20 and a base plate 21. The casing 20 has a box shape, and has an accommodation portion capable of accommodating the cassette 9 therein. The base plate 21 has a substantially square plate shape and is orthogonal to the front-and-rear direction. In front of the base plate 21, a feed portion 22A, attachment portions 22B to 22E, a winding portion 22F, a thermal head 24, a control board (not illustrated), and Hall sensors 28A and 28B (see Fig. 2) are provided. In the rear of the base plate 21, a ribbon drive source 26 (see Fig. 2) and a head drive source 27 (see Fig. 2) are provided.

The feed portion 22A and the winding portion 22F are arranged in the horizontal direction, at the approximate center of the base plate 21 in the vertical. The attachment portion 22B is provided at the upper right corner of the base plate 21. The attachment portion 22C is provided at the lower right corner of the base plate 21. The attachment portion 22D is provided at the lower left corner of the base plate 21. The attachment portion 22E is provided at the upper left corner of the base plate 21. When the cassette 9 is attached to the printing device 2, the shafts 92A to 92F are connected to the feed portion 22A, the attachment portions 22B to 22E, and the winding portion 22F, respectively. The feed roll 90A wound around the spool 921 of the shaft 92A is attached to the feed portion 22A. The winding roll 90B wound around the spool 922 of the shaft 92F is attached to the winding portion 22F.

The ribbon drive source 26 (see Fig. 2) includes a first ribbon motor 26A and a second ribbon motor 26B (see Fig. 2). The first ribbon motor 26A and the second ribbon motor 26B are stepping motors. A rotating shaft of the first ribbon motor 26A is connected to the feed portion 22A. The first ribbon motor 26A rotationally drives the feed portion 22A. A rotating shaft of the second ribbon motor 26B is connected to the winding portion 22F. The second ribbon motor 26B rotationally drives the winding portion 22F. When the feed portion 22A and the winding portion 22F rotate in a state where the cassette 9 is attached to the printing device 2, the ink ribbon 9A is conveyed in the printing device 2 while being guided in contact with the shafts 92B to 92E between the feed roll 90A and the winding roll 90B. The movement direction of the ink ribbon 9A conveyed between the attachment portions 22C and 22D is referred to as the "convey direction of the ink ribbon 9A".

The thermal head 24 is provided below the approximate center of the front surface of the base plate 21 in the vertical direction and at a portion between the attachment portions 22C and 22D. The thermal head 24 is a line thermal head including a plurality of heating elements 24A linearly arranged in the front-and-rear direction. The thermal head 24 contacts a portion, which is stretched between the shafts 92C and 92D, of the ink ribbon 9A conveyed from the feed roll 90A toward the winding roll 90B of the cassette 9 from above. The print medium P and the ink ribbon 9A is disposed between the thermal head 24 and the platen roller Q disposed below the printing device 2. The thermal head 24 performs printing on the print medium P by heating the ink ribbon 9A while pressing the ink ribbon 9A against the print medium P.

The head drive source 27 (see Fig. 2) includes a first head motor 27A and a second head motor 27B (see Fig. 2). The first head motor 27A and the second head motor 27B are stepping motors. The first head motor 27A is connected to the thermal head 24 through a gear. The gear moves the thermal head 24 in the vertical direction by rotational drive of the first head motor 27A. The thermal head 24 approaches the platen roller Q by moving downward and is separated from the platen roller Q by moving upward. The second head motor 27B is connected to the thermal head 24 through a pulley and a belt. The pulley and the belt move the thermal head 24 in the horizontal direction by the rotational drive of the second head motor 27B. The movement direction (horizontal direction) of the thermal head 24 by the rotational drive of the second head motor 27B is orthogonal to both an extending direction (front-and-rear direction) of the rotation axis of the platen roller Q and the movement direction (vertical direction) of the thermal head 24 by the rotational drive of the first head motor 27A and parallel to the convey direction of the ink ribbon 9A. The thermal head 24 is movable within a rectangular range 240 by the first head motor 27A and the second head motor 27B.

The movable range 240 of the thermal head 24 will be described in detail. A virtual line extending in the vertical direction through the center of the platen roller Q and along the base plate 21 is referred to as a reference line B. The thermal head 24 is disposed at any one of a first position S1, a second position S2, and a third position S3 by moving in the vertical direction along the reference line B in response to the rotational drive of the first head motor 27A. The first position S1 corresponds to a position of the upper end of the range 240 among positions along the reference line B. In a state where the thermal head 24 is disposed at the first position S1, the heating element 24A is separated from the ink ribbon 9A.

The third position S3 corresponds to a position slightly above the lower end of the range 240 among positions along the reference line B. The third position S3 is the position of the thermal head 24 when the printing device 2 prints. A position of the heating element 24A when the thermal head 24 is disposed at the third position S3 is referred to as a "print position Sp". The print position Sp is the most protruding position upward of the side surface of the platen roller Q, in other words, is a position at which the side surface of the platen roller Q is closest to the thermal head 24 disposed at the first position S1 in the movement direction (vertical direction) of the thermal head 24 by the rotational drive of the first head motor 27A. Strictly speaking, the print position Sp is the position of the heating element 24A when the first head motor 27A is rotationally driven so as to have pressing strength necessary for the transfer of the ink ribbon 9A, in a state where the ink ribbon 9A is disposed between the printing position Sp and the thermal head 24 at the most protruding position upward among the positions on the side surface of the platen roller Q.

The second position S2 is positioned slightly above the third position S3. The second position S2 is closer to the platen roller Q than the first position S1 and is farther from the platen roller Q than the third position S3. The heating element 24A contacts the ink ribbon 9A in a state where the thermal head 24 is disposed at the second position S2 and the third position S3.

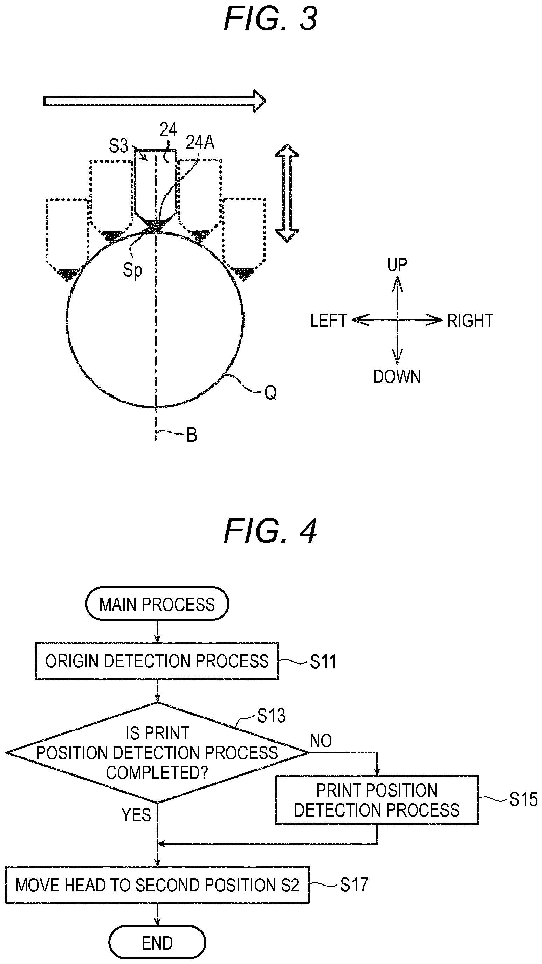

The thermal head 24 is further movable in the horizontal direction from the state of being disposed at the third position S3 by the rotational drive of the second head motor 27B. For example, in a case where the heating element 24A moves along the side surface of the platen roller Q when the thermal head 24 moves in the horizontal movement of the thermal head, the thermal head 24 moves downward as it is separated from the reference line B in the horizontal direction (see Fig. 3). For that reason, when the thermal head 24 moves in the horizontal direction so that the heating element 24A moves along the side surface of the platen roller Q, the print position Sp corresponds to the position of the heating element 24A when the thermal head 24 has moved most upward.

A controller 2A and a storage unit 2B (see Fig. 2) are mounted on the control board. The Hall sensors 28A and 28B (see Fig. 2) are provided in the vicinity of the thermal head 24. The Hall sensors 28A and 28B detect strength of a magnetic field of a magnet attached to the thermal head 24, and output a signal indicating the strength of the detected magnetic field to the controller 2A. The strength of the magnetic field detected by the Hall sensor 28A changes in response to the movement of the thermal head 24 in the vertical direction. For that reason, the controller 2A can specify the position of the thermal head 24 in the vertical direction based on the signal output from the Hall sensor 28A. The strength of the magnetic field detected by the Hall sensor 28B changes in response to the movement of the thermal head 24 in the horizontal direction. For that reason, the controller 2A can specify the position of the thermal head 24 in the horizontal direction based on the signal output from the Hall sensor 28B.

### <Controller 7>

As illustrated in Fig. 2, a controller 7 is interposed between the PC 5 and the external device 8 and the printing device 2. The controller 7 outputs data necessary for the printing device 2 to perform printing to the printing device 2. As a specific example of data output from the controller 7 to the printing device 2, data of a print image may be included. The controller 7 also transmits signals output from a PC 5 and an external device 8 to the printing device 2. Examples of the signals output from the PC 5 or the external device 8 include a preparation signal for setting the printing device 2 in a printable state, and a speed signal indicating a convey speed of the print medium P. Examples of the signals output from the external device 8 include a convey start signal/convey stop signal of the printing medium P, and a printing signal for notifying the printing time of the printing medium P.

### <Electrical Configuration>

An electrical configuration of the printing system 1 will be described with reference to Fig. 2. The printing device 2 includes the controller 2A, the storage unit 2B, a communication interface 2C, the thermal head 24, the first ribbon motor 26A, the second ribbon motor 26B, the first head motor 27A, the second head motor 27B, and the Hall sensors 28A and 28B. The controller 2A is electrically connected to the storage unit 2B, the communication interface 2C, the thermal head 24, the first ribbon motor 26A, the second ribbon motor 26B, the first head motor 27A, the second head motor 27B, and the Hall sensors 28A and 28B.

The controller 2A executes a main process (see Fig. 4) by reading and executing a program stored in the storage unit 2B. A program for the controller 2A to execute the main process is stored in the storage unit 2B. The communication interface 2C is an interface element for communicating between the printing device 2 and the controller 7. The communication interface 2C is connected to the controller 7 through a communication cable

The thermal head 24 energizes the heating element 24A in response to a control signal from the controller 2A to cause the heating element 24A to generate heat. The first ribbon motor 26A rotates in response to a pulse signal output from the controller 2A, and feeds out the ink ribbon 9A from the feed roll 90A of the cassette 9. The second ribbon motor 26B rotates in response to the pulse signal output from the controller 2A, and winds the ink ribbon 9A around the winding roll 90B of the cassette 9. The first head motor 27A rotates in response to the pulse signal output from the controller 2A, and moves the thermal head 24 in the vertical direction. The second head motor 27B rotates in response to the pulse signal output from the controller 2A, and moves the thermal head 24 in the horizontal direction. The Hall sensors 28A and 28B detect the strength of the magnetic field of the magnet attached to the thermal head 24, and output a signal indicating the strength of the detected magnetic field to the controller 2A.

The controller 7 includes a controller 7A, a storage unit 7B, and communication interfaces 7C and 7D. The communication interface 7C is an interface element for communicating between the printing device 2 and the controller 7. The communication interface 7C is connected to the printing device 2 through a communication cable. The communication interface 7D is an interface element for communicating between the external device 8 and the PC 5 and the controller 7. The communication interface 7D is connected to the PC 5 and the external device 8 through a communication cable. Data necessary for the printing device 2 to perform printing is stored in the storage unit 7B. The controller 7A is electrically connected to the storage unit 7B and the communication interfaces 7C and 7D. The controller 7A reads data necessary for the printing device 2 to perform printing from the storage unit 7B, and outputs the data to the printing device 2 through the communication interface 7C. The controller 7A detects a signal received from the PC 5 or the external device 8 through the communication interface 7D, and outputs the signal to the printing device 2 through the communication interface 7C.

The external device 8 includes a controller 8A, an operation panel 8B, and a communication interface 8C. An instruction to the external device 8 is input to the operation panel 8B. The communication interface 8C is an interface element for communicating between the external device 8 and the controller 7. The communication interface 8C is connected to the controller 7 through a communication cable. The controller 8A is electrically connected to the operation panel 8B and the communication interface 8C. The controller 8A receives an instruction input to operation panel 8B. The controller 8A outputs various signals to the controller 7 through the communication interface 8C.

### <Overview of Printing Operation>

An overview of a printing operation in the printing system 1 will be described with reference to Fig. 1. The thermal head 24 of the printing device 2 is disposed at the first position S1 when the cassette 9 is attached. The operator inputs an instruction for bring the printing device 2 into a printable state to the PC 5. In response to the instruction input, the preparation signal is output from the PC 5. The printing device 2 receives the preparation signal through the controller 7. The printing device 2 rotationally drives the first head motor 27A in response to receiving the preparation signal, and moves the thermal head 24 downward from the first position S1 to the second position S2. The controller 7 outputs data indicating the print image to the printing device 2. The printing device 2 receives the data and stores the data in the storage unit 2B.

In response to the start of convey of the print medium P by the external device 8, a convey start signal for starting convey of the print medium P and a speed signal indicating the convey speed of the print medium P are output from the external device 8. The printing device 2 receives the convey start signal and the speed signal through the controller 7. The printing device 2 rotationally drives the first ribbon motor 26A and the second ribbon motor 26B and the feed roll 90A and the winding roll 90B so that the ink ribbon 9A is conveyed at a speed synchronized with the convey speed indicated by the speed signal. The ink ribbon 9A moves to the left at a speed synchronized with the print medium P in the convey path. The ink ribbon 9A and the print medium P run in parallel to each other to the left.

A print signal notifying the printing time for the print medium P is repeatedly output from the external device 8. The printing device 2 repeatedly receives the print signal through the controller 7. The printing device 2 rotationally drives the first head motor 27A in response to receiving the print signal, and moves the thermal head 24 downward from the second position S2 to the third position S3. The thermal head 24 sandwiches the ink ribbon 9A and the print medium P between the thermal head 24 and the platen roller Q, and presses the ink ribbon 9A against the print medium P. The heating element 24A of the thermal head 24 generates heat based on data stored in the storage unit 2B. Ink of the ink ribbon 9A is transferred to the print medium P, and the print image is printed. After printing the print image, the first head motor 27A is rotationally driven and the thermal head 24 moves upward from the third position S3 to the second position S2.
Printing of the print image is repeatedly performed each time a print signal is received in the printing device 2.

In response to the stop of convey of the print medium P by the external device 8, a convey stop signal for stopping the conveyance of the print medium P is output from the external device 8. The printing device 2 receives the convey stop signal through the controller 7. The printing device 2 stops rotation of the first ribbon motor 26A and the second ribbon motor 26B. With this configuration, rotation of the feed roll 90A and the winding roll 90B is also stopped, and the conveyance of the ink ribbon 9A is stopped.

### <Origin Detection Process of Thermal Head 24>

The controller 2A of the printing device 2 executes an origin detection process in order to obtain information on an origin position X which is a reference when moving the thermal head 24 in the vertical direction and the horizontal direction by the first head motor 27A and the second head motor 27B. As illustrated in Fig. 1, the origin position X is disposed between the first position S1 and the second position S2 among the positions along the reference line B. In the origin detection process, driving conditions (hereinafter referred to as "origin position information") of the first head motor 27A and the second head motor 27B in a state where it is determined that the thermal head 24 is disposed at the origin position X based on values of the Hall sensor 28A and the Hall sensor 28B are acquired and stored in the storage unit 2B. The controller 2A can move the thermal head 24 from the origin position X to the first position S1, the second position S2, and the third position S3 by rotationally driving the first head motor 27A and the second head motor 27B based on origin position information stored in the storage unit 2B.

### <Print position Detection Process>

The controller 2A of the printing device 2 executes a print position detection process to detect the print position Sp (see Fig. 1). As illustrated in Fig. 3, in the print position detection process, the thermal head 24 is moved to the right by the rotational drive of the second head motor 27B in a state where the heating element 24A of the thermal head 24 is in contact with the side surface of the platen roller Q. The thermal head 24 moves upward when moving to the right in a state of being disposed to the left of the reference line B. The thermal head 24 moves downward when moving to the right in a state of being disposed to the right of the reference line B. At the same time, positions of the thermal head 24 in the vertical and horizontal directions are specified based on the signals output from the Hall sensors 28A and 28B. The controller 2A detects, as the print position Sp, the position of the heating element 24A when the movement direction of the thermal head 24 changes from upward to downward. The controller 2A stores setting information (hereinafter referred to as "print position information") indicating the detected print position Sp in the storage unit 2B.

### <Main Process>

A main process will be described with reference to Fig. 4. The main process is started by the controller 2A of the printing device 2 when the preparation signal output from the printing device 2 is received through the communication interface 7C. The main process is executed before printing is started. At the point in time of start of the main process, the thermal head 24 is disposed at the first position S1. The controller 2A executes an origin detection process (S11). The controller 2A stores origin position information acquired by the origin detection process in the storage unit 2B.

The controller 2A determines whether the print position detection process is completed (S13). When the print position information is stored in the storage unit 2B, the controller 2A determines that the print position detection process is completed (YES in S13). In this case, the controller 2A advances the process to S17. On the other hand, when the print position information is not stored in the storage unit 2B, the controller 2A determines that the print position detection process is not completed (NO in S13). The controller 2A executes the print position detection process (S15). That is, the print position detection process is performed only when it is determined that the print position information is not stored in the storage unit 2B, and is not performed when the print position information is stored in the storage unit 2B. The controller 2A detects the print position Sp by the print position detection process, and stores the print position information in the storage unit 2B. The controller 2A advances the process to S17.

The controller 2A allows a current to be supplied to the first head motor 27A. Thus, the controller 2A moves the thermal head 24 from the first position S1 to the second position S2 (S17). The controller 2A ends the main process.

For example, when the controller 2A receives the convey start signal, the speed signal, and the print signal through the communication interface 7C after the main process is ended, the controller 2A performs printing on the print medium P based on the method described in the "Overview of Printing Operation".

### <Main Functions and Effects>

When it is determined that the print position information, which is setting information indicating the print position Sp, is not stored in the storage unit 2B (NO in S13), the printing device 2 executes the print position detection process (S15). On the other hand, when it is determined that the print position information is stored in the storage unit 2B (YES in S13), the printing device 2 does not execute the print position detection process. In this case, the printing system 1 can shorten the time required to start printing as compared to the case where the print position detection process is executed regardless of whether the print position information is stored in the storage unit 2B.

In response to receiving a preparation instruction output from the PC 5, the printing device 2 executes the print position detection process (S15) as necessary. The preparation instruction is output from the PC 5 to bring the printing device into a printable state. For that reason, since the printing device 2 can detect the print position when being brought into the printing possible state in response to the preparation signal, the printing device 2 can start printing quickly based on the detected print position. The printing system 1 can suppress an increase in processing load of the printing device 2 by not executing the print position detection process when the print position is unnecessary.

The Hall sensors 28A and 28B detect the position of the thermal head 24 based on the change of the magnetic field. For that reason, even when the Hall sensors 28A and 28B are contaminated by dust or the like, the position of the thermal head 24 can be appropriately detected.

The print position Sp is the most protruding position upward of the side surface of the platen roller Q. In other words, the print position Sp is a position at which the side surface of the platen roller Q is closest to the thermal head 24 disposed at the first position S1 in the vertical direction. In this case, the printing device 2 can properly sandwich the printing medium P and the ink ribbon 9A between the heating element 24A of the thermal head 24 disposed at the print position and the platen roller Q during printing. Accordingly, the printing system 1 can appropriately transfer ink of the ink ribbon 9A to the printing medium P by causing the heating element 24A to generate heat in this state.

The printing device 2 detects the print position Sp based on the change in the vertical position of the thermal head 24 when the heating element 24A of the thermal head 24 is moved along the side surface of the platen roller Q in the horizontal direction. In this case, the printing system 1 can accurately detect, as the print position Sp, the most protruding position upward on the platen roller Q.

The printing device 2 executes the print position detection process (S15) only when it is determined that the print position information is not stored in the storage unit 2B (NO in S13), and does not execute the print position detection process when is determined that the print position information is stored in the storage unit 2B (YES in S13). In this case, in the printing system 1, frequency at which the print position detection process is performed can be suppressed, and thus it is possible to shorten the time required to start printing.

### <Modification Example>

The present invention is not limited to the embodiment described above, and various modifications may be made thereto. In the embodiment described above, the main process is executed by the controller 2A of the printing device 2. In contrast, the external device 8 may be included in the printing system 1. A part or all of the main process may be executed by the controller 7A of the controller 7 or the controller 8A of the external device 8. The print position Sp may be detected by a method different from the print position detection process described above. For example, the controller 2A may move the thermal head 24 to the right little by little while reciprocating the thermal head 24 in the vertical direction. The controller 2A may specify the positions of the thermal head 24 in the vertical direction and the horizontal direction when the downward movement is stopped by the heating element 24A contacting the platen roller Q by the hall sensors 28A and 28B. The controller 2A may detect the print position Sp based on the specified position of the thermal head 24.

The timing at which the controller 2A executes the print position detection process is not limited to the timing after the preparation signal is received. For example, when the cassette 9 is attached to the printing device 2, there is a high possibility that printing will start, and thus the controller 2A may execute the print position detection process as necessary. The sensor that detects the position of the thermal head 24 is not limited to the Hall sensors 28A and 28B. For example, the position of the thermal head 24 may be detected by a contact-type displacement sensor provided in the vicinity of the thermal head 24. The position of the thermal head 24 in the vertical direction may be determined based on an amount of rotation of the first head motor 27A based on the origin position information. The position of the thermal head 24 in the horizontal direction may be determined based on the amount of rotation of the second head motor 27B based on the origin position information. The definition of the print position Sp is not limited to that described in the embodiment described above. For example, the print position Sp may be a position at which the side surface of the platen roller Q is moved to the left or right with respect to the most protruding position upward.

### <Others>

The first direction is an example of the "vertical direction" in the present invention. The second direction is an example of the "horizontal direction" in the present invention. The communication interface 2C is an example of the "interface" of the present invention.

When setting information of the print position is not stored in the storage unit, the printing device executes the process of detecting the print position. On the other hand, when the print position setting information is stored in the storage unit, the printing system does not execute the process of detecting the print position. In this case, the printing system shortens the time required to start printing as compared to when the process of detecting the print position is executed regardless of whether the setting information of the print position is stored in the storage unit.

## Claims

1. A printing system, comprising:
a platen roller;
a storage unit;
a controller; and
a printing device that includes:
a thermal head;
a head drive source that is configured to move the thermal head in a first direction along which the thermal head approaches or separates from the platen roller; and
at least a sensor that is configured to detect a position of the thermal head, wherein the controller is configured to:
determine, before a start of printing, whether setting information of a print position, which is a position of a heating element of the thermal head during printing, is stored in the storage unit,
detect the print position with the head drive source and the sensor when it is determined that the setting information is not stored in the storage unit, and
cause the head drive source to move the thermal head from a first position to a second position, which is closer to the platen roller than the first position and farther from the platen roller than a position of the thermal head in a state where the heating element is disposed at the print position, when it is determined that the setting information is stored in the storage unit.

2. The printing system according to claim 1, further comprising an interface,
wherein the controller is configured to:
determine whether the setting information of the print position is stored in the storage unit when a preparation instruction for bringing the printing device into a printable state is received through the interface before the start of printing; and
detect the print position with the head drive source and the sensor when it is determined that the setting information is not stored in the storage unit.

3. The printing system according to claim 1 or 2, wherein the sensor includes a Hall sensor.

4. The printing system according to any one of claims 1 to 3, wherein the print position is a position on a side surface of the platen roller and closest to the thermal head disposed at the first position in the first direction.

5. The printing system according to claim 4, wherein the head drive source is further configured to move the thermal head in a second direction which is orthogonal to the first direction and intersects a rotation axis of the platen roller, and
the controller is configured to detect the print position by detecting the position of the thermal head with the sensor when the thermal head is moved in the second direction in a state where the heating element is in contact with the side surface of the platen roller.

6. The printing system according to any one of claims 1 to 5, wherein the controller is configured to detect the print position with the head drive source and the sensor only when it is determined that the setting information is not stored in the storage unit, and not detect the print position when it is determined that the setting information is stored in the storage unit.
